Europäisches Patentamt

(19) European Patent Office

Office européen des brevets

(11) Publication number: **0 247 522 B1**

## (12) EUROPEAN PATENT SPECIFICATION

(45) Date of publication of patent specification: **13.05.92**

(21) Application number: **87107406.8**

(22) Date of filing: **21.05.87**

(51) Int. Cl.⁵: **H05K 7/14**, H05K 7/20, H05K 9/00, H05K 5/00

(54) **Electronic equipment housing.**

(30) Priority: **29.05.86 US 868408**

(43) Date of publication of application:
**02.12.87 Bulletin 87/49**

(45) Publication of the grant of the patent:
**13.05.92 Bulletin 92/20**

(84) Designated Contracting States:
**DE ES FR GB IT**

(56) References cited:
**EP-A- 0 111 183        EP-A- 0 132 152**
**DE-B- 2 140 376        DE-B- 2 832 575**
**DE-U- 7 528 808        GB-A- 2 101 412**

(73) Proprietor: **Bull HN Information Systems Inc.**
**Corporation Trust Center 1209 Orange Street**
**Wilmington Delaware(US)**

(72) Inventor: **Dillon, Richard R.**
**20 Appleby Road**
**Wellesley Massachusetts 02181(US)**
Inventor: **Henneberg, Helmut H.**
**277 Norfolk Street**
**Canton Massachusetts 02021(US)**
Inventor: **Soares, Antonio P. S.**
**44 Orchard Street**
**Cambridge Massachusetts 02140(US)**
Inventor: **Yoshida, Paul S.**
**24 Lincoln Street**
**Newton Highlands Massachusetts 02161(US)**

(74) Representative: **Frohwitter, Bernhard,**
**Dipl.-Ing. et al**
**Bardehle-Pagenberg-Dost-Altenburg & Part-**
**ner Patent- und Rechtsanwälte Galileiplatz 1**
**Postfach 86 06 20**
**8000 München 80(DE)**

# Description

## Field of the Invention

This invention relates to packaging for electronic circuitry and more particularly to housings for packaging electronic equipment.

## Background of the Invention

In the prior art, electronic computer circuitry and equipment have typically been packaged in metal housings, different sides or panels of which are removable to gain access to the circuits and equipment in the interior of the housing. Alternatively, an entire housing cover is removed as a single piece from the top of the equipment housing to thereby gain access to the circuits and other equipment inside. Power and signal cables to and between a group of housings in a computer system typically connect to connectors on the rear of the housings. Various switches are also located on the rear of the housings. Access to and removal of printed circuit cards and other modules such as power supplies, disk drives, and fans are typically achieved by removing a front panel of a housing to gain access to these elements.

As an example of a modular housing for a computer system, reference is made to EP patent application No. 132,152 having three modules which are arranged horizontally in a row, side-by-side.

There are many shortcomings with these prior art electronic equipment housings. For example, the rear of housing cabling arrangement requires that the housings be spaced far enough from a wall to provide room for the cables, and so that access may be had to the cables and switches at the rear of the housings. This creates unused floor space that may well be used more efficiently. In addition, the cables lying on the floor behind the housings create an unsightly mess which is tolerated only because it is out of sight. The problem is made worse by the fact that the cables are usually standard lengths and are typically too long, thus requiring that the excess cable be coiled or just lie in disarray. To minimize the wasted floor space the housings are sometimes located as close to the wall as possible, but this creates another problem of access to the cables, their connectors, switches and even rear of housing accessed interior components. To gain working access to the rear of the housings they must be temporarily moved further away from the wall which often creates other problems of inadvertently disconnecting and/or damaging connectors.

Access to printed circuit cards and other equipment through the front of a housing by removing its front panel is not difficult if the housing is relatively tall and the interior can be accessed by a person while standing up. However, many modern housings are only two to three feet tall. The result is that a person must sit down or get down on their hands and knees to look into the housing and to remove printed circuit cards and other modules therefrom. This is difficult for many people including tall people, a person with arthritis in their joints, and for women wearing dresses.

Another problem with some prior art housings is that printed circuit cards having temperature sensitive components thereon are sometimes mounted adjacent to heat generating equipment such as power supplies such that the same cooling air is circulated over the printed circuit cards and the high heat generating components such as the power supplies. If the heat is passed over the printed circuit cards first, the air is warmed before it passes over components such as power supplies and the cooling effect is decreased. This requires using larger fans which require more space and use more power, or the maximum temperature of the room in which the housings may be located must be lower.

Thus, there is a need in the prior art for an electronic equipment housing which may be located close to a wall to conserve floor space. In addition, there is a need for a way to access printed circuit cards and most other equipment in the housing without having to get down on the floor, for a cabling arrangement which can minimize exterior cabling by keeping inter-housing cables inside the housings, and for using standard length cables while minimizing excess coiled or loosely piled cable. Further, there is a need for an equipment arrangement in the housings that provides adequate cooling via convection and with the smallest possible cooling fans, and thereby do not contribute to the heating problem.

## SUMMARY OF THE INVENTION

The aforementioned needs of the prior art are met by our novel, modular electronic equipment housings. When our novel housings are positioned contiguous to each other in a computer system configuration, the sides of the housings that are adjacent to each other are removed. The tops of these housings are hinged, thereby allowing for easy top access to vertically mounted printed circuit boards and other electronic components inside the housings. Common system electronic equipment such as disk drives and most input/output cable interfaces are mounted in a common equipment housing, while printed circuit cards containing computer circuitry such as processors and memory are mounted in a different housing.

No cabling between individual ones of the novel housings lies on the floor behind the housings. AC power cables and some communication cables are at the rear of and enter the housings. Also, cables to peripheral equipment such as printers are at the rear of and enter the common equipment housing which is located at the end of a row of housings in a system configuration. This simplifies access to the peripheral cable connections. Inside each PC card housing there are cable raceways parallel to the front panel and located at the top front and at the top rear of the housing. With housing side panels removed between contiguous PC card housings, the cable raceways in the housings are coaxially aligned. Cables between circuits and other components inside the PC card housings and the common equipment housing are in these interior cable raceways. The position of the cable raceways and the cables therein doesn't interfere with convection cooling of the printed circuit boards and other electronic components, doesn't interfere with the flow of air from cooling fans, and doesn't interfere with access to these PC cards and other components via the hinged top panel of the equipment housings.

Input and output signal cables all connect to a bulkhead connector array on one side of the common equipment housing which is located at one end of a row of housings in a computer equipment system configuration. The connectors are mounted on swing out doors that permit easy access to change connectors, their position, and interior wiring thereto. In addition, the connectors are organized in an arrangement that permits cables coming from any one of the adjacent housings to be of a standard length and none of these cables need be coiled due to excess cable.

In PC card housings the power supplies for the PC cards are mounted to one side of the housing. Fans are used to cool the power supplies and the printed circuit cards, and air is drawn in through slots through the front panel of the housing and exits through slots in the rear panel of the housing. Air that passes over either the printed circuit cards or the power supplies doesn't pass over other components, so maximum cooling is achieved.

The slots through the front and rear panels of the housings, and through which cooling air passes, have conductive screening behind and across them to minimize radio frequency interference (RFI) escaping from the housings. In addition, the housings and the removable panels including the hinged housing top are painted with a conductive paint, and all removable or opening panels have conductive seals thereon that contact the conductive paint to minimize RFI escaping from the housings.

BRIEF DESCRIPTION OF THE DRAWINGS

The invention will be better understood upon reading the following detailed description in conjunction with the drawing in which:

Figure I illustrates a three-dimensional view of modular housings in accordance with the teaching of the present invention, and one housing has its hinged top open;

Figure 2 shows the interior of the two basic types of equipment packaging housings in accordance with the teaching of the invention;

Figure 3 shows the organization of the cables in the cable raceways, and the bulkhead connector interface that permits one cable length to be used from each housing to the connector interface; and

Figure 4 is a top view of cables internal to the cabinets going to the bulkhead connector interface and to a swing out auxiliary bulkhead connector interface at the rear of the common equipment housing for connection of cables from peripheral equipment.

DETAILED DESCRIPTION

In Figure I is shown a three dimensional view of a typical common housing I0 and two adjacent PC card housings II and IIA. In a small system configuration there is one housing I0 and one housing II, but in larger system configurations there are more housings II, of which only one such extra housing IIA is shown in Figure I. Housing I0 has a latched lift-off top cover 49 that is easily removed to gain access to the interior of housing I0. Housings II and IIA have a hinged top cover I9 and underneath that a clear plastic cover 46. Housing II is shown with its hinged metal top I9 and its internal hinged clear plastic top cover 46 open, and an exemplary printed circuit card 34 is shown partially removed. Hinged top I9 is equipped with a mechanism (not shown) that permits it to be opened and then remain opened by itself, without the need for a support arm, until top I9 is closed.

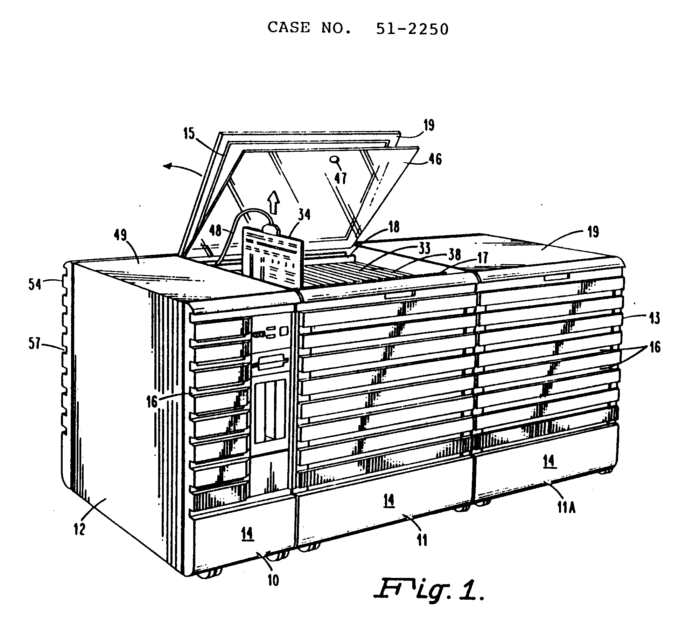

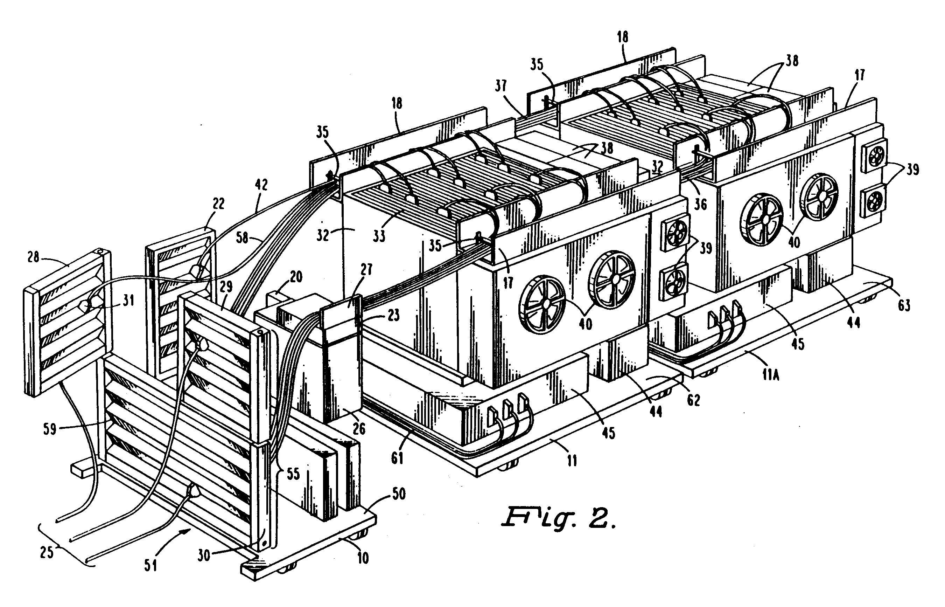

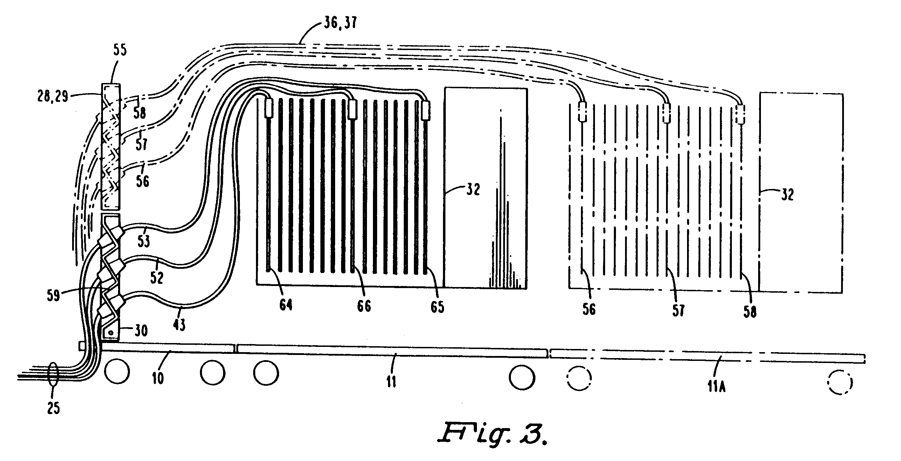

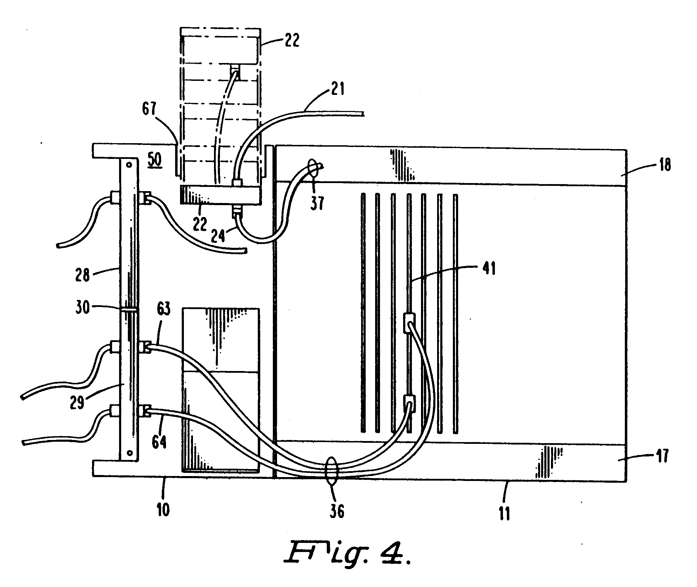

There is a cable 48 shown connected to card 34 via an edge connector which would normally be disconnected before card 34 is removed. Around the bottom side of hinged top cover I9 is an RFI gasket I5 which makes a good RFI seal to the top edges of housing II when top I9 is closed. To assist in this RFI seal, and with RFI suppression generally, the housings are all painted with a conductive paint. Front panels I4 are shown mounted on the front of housings I0, II and IIA, but they may

easily be removed to gain access to a very few electrical components, such as fans, that need infrequent maintenance or replacement. These components are better shown in Figure 2.

Housings l0, ll, and llA all have removable side panels. Each has a front panel l4, a left side panel l2, a right side panel l3, and a rear panel 54. When two housings are mounted next to each other the side panels l2 and l3 between them are removed, and the housings are bolted together. In Figure l the left side panels l2 are removed from housings ll and llA, and the right side panels l3 are removed from housings l0 and ll. This leaves left side panel l2 on housing l0 and right side panel l3 on housing llA, as shown. This permits inter-housing cables in the internal cable raceways l7 and l8 to be contained inside housings l0, ll, and llA.

Left side panel l2 on housing l0 covers a bulkhead connector interface 55 that is not seen in Figure l, but is shown in detail in Figure 2. Interface 55 is where cables with connectors entering housing l0 connect to mating connectors on cables that go to housings l0, ll, and llA.

Around the underside of each of the hinged housing tops l9 of housings ll and llA there is an RFI gasket l5 which makes an RFI seal with the top of housings ll and llA when the tops l9 are closed to minimize RFI emissions. Similarly, around the inside edge of front panel l4, right side panel l3, left side panel l2, and rear panel 54 of housings l0, ll, and llA there are also RFI seals (not shown) which make an RFI seal respectively with the front, left, right and rear sides of the housings when they are fastened to the housings. When housings l0, ll, llA are bolted together with some of their side panels l2 and l3 removed, as described above, there is still an RFI tight joint. To aid in the RFI suppression, housings l0, ll, and llA, including their tops l9 and sides l2, l3, l4 and 54 are all painted with a conductive paint.

Inside of housings ll and llA are two cable raceways l7 and l8. Only the raceways l7 and l8 in housing ll are shown. Cable raceway l7 is at the top front of housing ll and is parallel to the front of the housing. Cable raceway l8 is at the top rear of housing ll and is also parallel to the front of the housing. When two or more housings ll and llA are bolted together without side panels l2 and l3 between them in a computer system configuration, as shown in Figure l, the top front cable raceways l7 in each adjacent housing ll and llA are in coaxial alignment with each other and, likewise, the top rear cable raceways l8 in each adjacent housing are in coaxial alignment with each other. This provides a cable path for inter-housing cables 36 and 37 (not shown in Figure l, but shown in Figure 2) to and between the printed circuit cards 33 and 34 and other components 38 inside the adjacent housings l0, ll and llA that is completely enclosed. This provides easy cable access without having to go behind the housings l0, ll and llA for the inter-housing cables. In addition, by having the inter-housing cables 36 and 37 inside of the housings l0, ll, and llA not only is neatness achieved by minimizing the number of cables on the floor behind housings l0, ll and llA but, importantly, these cables 36 and 37 are shielded by being inside the housings l0, ll and llA to provide additional suppression of RFI caused by signals on the wires within the cables.

Also located inside the top of housings ll and llA, underneath hinged top cover l9, is a safety top cover 46 which is made of clear plastic. Top cover 46 is equipped with a lock 47. Only maintenance personnel have a key to open plastic top 46 for maintenance purposes that includes removing PC cards 33 and power supplies 38, and other personnel are thereby excluded from gaining access to the electronics for safety purposes since there are exposed terminals with voltages thereon. However, the non-maintenance personnel can see various operational status lights (not shown) beneath the clear plastic cover 46.

Through front panels l4 on the front of housings l0, ll and llA are seen slots l6. Not seen is a conductive screen behind the slots l6 which provides RFI shielding. Similarly, there are slots l6 through rear panels 54 on the rear of housings l0, ll and llA which are also RFI shielded by conductive screening. These front and rear slots l6 provide a passage for cooling air to be drawn in through the front slots l6 and out through the rear slots l6 to cool the printed circuit boards 33 and other electrical components such as power supplies 38 inside of housings l0, ll and llA.

In Figure 2 is shown a three dimensional view of the interior elements of adjacent equipment housings l0, ll and llA. Only the three housings are shown in Figure 2, but any number of housings may be bolted together depending upon a computer system configuration to be implemented. Also, only two types of representative housings l0 and ll are shown, but those skilled in the art can mount other types of electronic equipment in the novel cabinets in accordance with teaching of the present invention. Hinged housing top l9, and left, right, front, and rear panels l2, l3, l4, and 54 are not shown with housings l0, ll, and llA in Figure 2 so that other details of the novel electronic equipment housing may be seen. While the mechanical parts of housings l0, ll, and llA as described above with reference to Figure l are basically the same, there are some differences other than those detailed with reference to Figure l. For example, in the interior of housings ll and llA are mounted printed circuit card trays 32, cooling fans 39 and 40, and power supplies 38; while the interior of housing l0 is used to mount common system components such as a floppy disk drive 23, an operators panel 27, a power supply 20, a tape unit 26 using tape cartridges to back up daily transactions in the computer, and a bulkhead connector interface 55 via which input and output cables 25 are connected to the circuits and other components inside housings l0, ll and llA. A left side panel l2 covers this bulkhead connector interface 55 so it is not seen in Figure l.

Bulkhead connector interface 55 is divided into three swing out doors 28, 29 and 30. Door 28 is hinged and swings out to the left as shown, while door 29 is hinged at its right edge and swings out to the right, and larger door 30 is hinged and swings out and down. As mentioned previously, these swing-out doors 28, 29 and 30 permit access to the connectors on cables 36 and 37 to change them, move them, or to change cable wiring to them. In a small system configuration only swing-out door 30 is utilized. As larger system configurations are created, swing-out doors 28 and 29 are added to handle additional cable connector connections.

As can be seen in Figure 2, swing-out doors 28, 29 and 30 each have a surface that is saw-tooth in shape. This saw-tooth shape creates a number of surfaces 59 which are angled to face downward on the outside of doors 28, 29 and 30. Through these surfaces 59 are punched rows of cutouts designed to latch and hold connectors on the ends of cables in cables 36 and 37, such as exemplary cable 58. With the connector 3l on the end of cable 58 latched to a surface 59, cable 58 forms upward over the top of the equipment inside of housing l0. Similarly, the angle of surfaces 59 causes ones of input/output cables 25 connected to connectors, such as connector 3l, latched at surface 59 to be formed downward. Cables 25 enter and exit housing l0 via a cutout 5l on the edge of base pan 50 of housing l0. When left side panel l2 is installed on housing l0 connector interface 55 cannot be seen. The result of using angled surfaces 59 as cable connector interface 55 is that there are no sharp bends in cables 25, 36 or 37. Latching connector housings that may be latched to cutouts through surfaces 59 and still latch to housings containing connectors of cables 25 is taught in U.S. Patent Application Serial No. 749,243, filed June 27, l985, entitled "Universal Internal Latch And Lock D Shell Connector", invented by Robert W. Noyes, and assigned to the same assignee as this present patent application.

In addition, a rear swing-out door 22 is provided at the rear of common equipment housing l0 via which cables to and from peripheral equipment (not shown), such as a printer, are connected to electronic equipment inside housings l0, ll, and llA. Cable 42 of cables 37 is shown connected to the inner side of bulkhead door 22. Bulkhead door 22 is assembled in the manner same as doors 28, 29 and 30 so the description in the last paragraph also applies to door 22. Further details of rear swing-out door 22 are shown in Figure 4 and are described further in this specification with reference thereto.

Base pan 50 of common equipment housing l0 also has a second cut-out 67 on its rear edge that is shown in Figure 4, but not in Figure 2, and through which cables from peripheral equipment such as printers enter housing l0 behind the removable rear panel 54 and connect to mating connectors latched to the auxiliary bulkhead connector door 22.

Housings ll and llA are the same and are used to mount vertical printed circuit (PC) card trays 32 in which are inserted PC cards 33. Printed circuit card trays 32 include plastic edge guides (not shown) that bind the edge of the cards to prevent them from accidentally dropping down into the card tray and thereby damaging the cards and the connectors at the bottom of trays 32.

On each of housings ll and llA are shown the cable raceways l7 and l8. The front cable raceway l7 and the rear cable raceway l8 in each of the housings ll and llA are in coaxial alignment with each other when housings ll and llA are contiguous to each other as shown. As previously mentioned, when two housings ll and llA are bolted together in a system configuration they have no side panels l2 and l3 between them. This allows cables 36 in front cable raceways l7 and cables 37 in rear cable raceways l8 to pass unimpeded between housings l0, ll and llA as shown. The position of cable raceways l7 and l8 in housings ll and llA, and the cables 36 and 37 therein, do not interfere with insertion or removal of PC cards 33 and 34 in or from PC card trays 32. Raceways 36 and 37 also do not interfere with the flow of fan blown cooling air through PC cards 33. In cable raceways l7 and l8 are mounted cable clamps 35 that are used to hold the cables 36 and 37 in the raceways, yet let them fan out to particular ones of printed circuit cards 33 in card tray 32.

In housings ll and llA ones of cables 36 and 37 going to a particular PC card 33 fan out of cable raceways l7 and l8 and the cable clamps 35 therein generally in line with a particular PC card 33. In this way they do not interfere with other PC cards, and particularly the insertion or removal of same. The ones of cables 36 and 37 that go to a particular PC card 33 have PC edge mount connectors thereon that plug onto the edge of the particular PC card in a manner well known in the art. When it desired to remove a PC card, the edge connectors are unplugged and the PC card is withdrawn vertically as shown for PC card 34 in Figure I. This organization of cable raceways I7 and I8 and cables 36 and 37 therein does not interfere with any of the PC cards 33.

Power supplies 38 supplying power to PC cards 33 in each of housings II and IIA are located to the right side of the inside of the housings as shown. Power supplies 38 are mounted vertically and are also accessed for maintenance and replacement via hinged top I9, and safety cover 46 on each of housings II and IIA.

Air circulating fans 39 and 40 are mounted to the front of housings II and IIA as shown to provide cooling air respectively to power supplies 38 and the printed circuit cards 33. Fans 39 pull air in through the slots I6 in the front panel I4 (both not shown in Figure 2) of housings II and IIA, passes it over the power supplies 38 to cool them, and the air exits the inside of housings II and IIA via the slots I6 through the rear panel 54 (both not shown in Figure 2). Fans 40 pull air in through the slots I6 in the front panel I4 (both not shown in Figure 2) of housings II and IIA, passes it through the PC cards 33 to cool them, and the air exits the inside of housings II and IIA via the slots 57 through the rear panel 54 (both not shown in Figure 2). With this configuration the same air is not used to cool both power supplies 38 and PC cards 33 as is often done in the prior art. To access the cooling fans 39 and 40 the front panel I4 (not shown in Figure 2) is removed. However, cooling fans very seldom if ever need replacement so the inconvenience of having to go inside housings II and IIA through front panel I4 is seldom, if ever, necessary.

At the bottom of the inside of housings II and IIA are located power units 44 through which AC power is distributed to the power supplies 38 and other equipment, such as fans 39 and 40, needing AC power. Also located at the bottom of the inside of housings II and IIA are a flap chassis 45 to which the connectors of special cables 6I connect. These special cables 6I and an AC power cable (not shown) enter the rear of the housings II and IIA through a cutout (not shown) on the rear edge of base pan 62 and 63 respectively like cutouts 5I and 52 on base 50 of housing I0, and described previously in this specification.

Figure 3 shows a stylized front view of housings I0, II and IIA with inter-housing cables 36 and 37 going from PC cards 33 in card trays 32 to swing-out doors 28, 29 and 30 of bulkhead connector interface 55 in housing I0. Normally cables 36 and 37 lie in the cable raceways I7 and I8, but they are shown in an elevated position in Figure 3 to aid in understanding the novel cabling arrangement that is described herein. It can be seen that cable 43 is connected between PC card 64 in housing I0 which is closest to connector interface 55 to angled surface 59 at the lowest level of swing out door 30, while cable 53 is connected between PC card 65 farthest from connector interface 55 in housing II to angled surface 59 at the highest level of swing out door 30. Cable 52 is connected between an intermediate PC card 63 in PC card tray 32 of housing II to an angled surface 59 at a middle level of swing out door 30. Which middle level surface 59 of swing-out door 30 cable 52 is latched to is dependent on the distance of its other end from housing I0. This cable organization allows for one length of cable to be used between housing II and door 30 of connector interface 55 in housing I0. The previously described angular orientation of the connectors on the ends of cables 36 and 37 latched to the inner side of doors 28, 29 and 30 of connector interface 55, and of the connectors on the ends of cables 25 external to housing I0 mated to cables 36 and 37 is seen in Figure 3.

It can be seen in Figure 3 that cables 56, 57 and 58 of cables 36 and 37 going from housing IIA to doors 28 and 29 of bulkhead connector interface 55 in housing I0 are similarly organized. Since the cable organization is described in detail in the last paragraph it is not again described here for housing IIA.

In Figure 4 is seen a top view of the cabling arrangement of cables 36 and 37 inside housings I0 and II. It is seen how exemplary cables 63 and 64 edge connect between a PC card 4I and a mating connection through swing out door 30 of connector interface 55. Cables 63 and 64 and all other inter-housing cables terminating in housing II are the same length as mentioned previously. Cables 63 and 64 are arranged so that cable 64 which has to connect further to the middle of PC card 4I mates at door 30 closest to the front of housing I0, and cable 63 which connects to PC card 4I closest to the front of housing II mates at door 30 further to the rear of housing I0. This cable organization compensates for any excess cable as depicted in Figure 4. Although this cable arrangement is only shown with a couple of representative cables it applies to all inter-housing cables 36 and 37.

By coupling the previously described routing of inter-housing cables 36 and 37, as described with reference to Figures 3 and 4, to swing out doors 28, 29, and 30 dependent on on which cable raceway they are in and where on a PC card 33 they connect, the result is that one length cable may be used for all cables from one of housings II or IIA while not having excess cable length that produces coiled cables that is a common problem in the prior art.

Returning to Figure 4, therein is also shown swing-out auxiliary connector bulkhead 22 shown in its normal vertical position, and shown in phantom in its swing-out position. As previously described, door 22 is used for cabling connections to peripheral equipment. Thus, cable 2l comes from a piece of peripheral equipment such as a printer and connects via bulkhead 22 to cable 24 which connects to circuitry internal to housings l0, ll, or llA that will provide or receive signals to or from the peripheral equipment. It can be seen how when bulkhead 22 is in its swing-out position that the connector on cable 24 can easily be accessed to move the connector or to change wiring therein. Also shown in Figure 4 is cutout 67 on the rear edge of base pan 50 of housing l0, and through which cables to/from peripheral equipment pass.

While what has been described hereinabove is the preferred embodiment of the invention, it will be obvious to those skilled in the art that numerous changes may be made. For example, the cooling fans may be mounted at the rear of the housing to improve noise silencing. Or, different equipment arrangements may be used inside the housings. In addition, protrusions may be spaced along the top edge of the cable raceways to help position cables as they exit the raceway to edge connect to PC cards without interferring with insertion and removal of other PC cards.

## Claims

1. An electronic equipment housing having a basic housing frame with a bottom pan (62) and having left (12), right (13), front (14), and rear (54) side removable panels, said front and rear panels having slots therethrough for flow of cooling air to pass over electronic equipment (34) mounted inside said housing, characterized in that said basic housing frame comprises:

    a hinged top panel (19) mounted on the top of said housing frame, said top panel adapted to be opened to permit access to electronic equipment inside said equipment housing, and

    a channel-shaped cable raceway member (17) mounted inside and adjacent to the top of said equipment housing and parallel to and adjacent either said front or rear panel, said cable raceway being positioned such that when a second similar equipment housing is located adjacent to said equipment housing with side panels between the two housings removed, the cable raceways in said adjacent housings are coaxially aligned with each other and thereby provide a path for cables going to and between the electronic equipment mounted inside the equipment housings, and said raceway is positioned to hold said cables so that they do not interfere with access to electronic equipment mounted in said equipment housings.

2. The basic housing frame in accordance with claim 1 further characterized by:

    a hinged clear plastic safety door (46) underneath said hinged top panel, said safety door permitting visual observation of the electronic equipment mounted inside said equipment housing, but restricting access thereto.

3. The basic housing frame in accordance with claim 1 further characterized by:

    vertical printed circuit card trays (32) for mounting printed circuit cards inside said equipment housing, said cards being accessed to be inserted or removed from said equipment housing by opening said hinged top panel, and a card can be inserted or removed after disconnecting edge connect cable connectors connected to the card without interference from cables that are edge connected to other cards in the card tray, and also without interference from said cable raceway.

4. The basic housing frame in accordance with claim 1 further characterized by:

    conductive screening mounted behind said slots (16) in said front and rear panels to provide radio frequency interference suppression.

5. The basic housing frame in accordance with claim 4 further characterized by:

    means for suppressing radio frequency emissions generated by the electronic equipment inside said equipment housing, said suppressing means being mounted to provide an RFI seal between said top and side front and rear panels when they are closed or fastened to said housing frame.

6. The basic housing frame in accordance with claim 1 wherein said cable raceway member comprises:

    a first cable raceway (17) mounted adjacent the front of said frame at the top thereof,

    a second cable raceway (18) mounted adjacent the rear of said frame at the top thereof, and

    cable guide means (35) in said first and said second raceways for helping position cables exiting both said raceways to connect to printed circuit cards vertically mounted in said printed circuit card trays and to other electronic equipment, so that the printed circuit cards and the other electronic equipment can be inserted and removed without interference from cables connected to other cards mounted in said card trays or to other equipment mounted in said equipment housing.

**Revendications**

1. Boîtier pour équipements électroniques ayant un cadre de boîtier de base muni d'un plateau (62) et ayant des panneaux amovibles latéraux gauche (12), droit (13), avant (14) et arrière (15), lesdits panneaux avant et arrière ayant des fentes les traversant pour que de l'air de refroidissement puisse circuler sur las équipements électroniques (34) montés à l'intérieur dudit boîtier, caractérisé en ce que ledit cadre de boîtier de base comprend:
   un panneau supérieur articulé (19) monté sur le haut dudit cadre de boîtier, ledit panneau supérieur étant adapté à être ouvert pour permettre l'accès aux équipements électroniques se trouvant à l'intérieur dudit boîtier, et
   un élément formant chemin de câble en forme de goulotte (17) monté à l'intérieur et au voisinage du haut dudit boîtier pour équipements et parallèlement et au voisinage soit dudit panneau avant, soit dudit panneau arrière, ledit chemin de câbles étant disposé de manière à ce que, lorsqu'un second boîtier pour équipements semblable est placé de façon adjacente audit boîtier pour équipements, les panneaux latéraux séparant les deux boîtiers étant retirés, les chemins de câbles dans lesdits boîtiers adjacents soient coaxialement alignés les uns avec les autres et fournissent ainsi un trajet pour les câbles allant vers et entre les équipements montés à l'intérieur des boîtiers pour équipements, et ledit chemin de câbles étant disposé de manière à maintenir lesdits câbles de façon à ce qu'ils n'entravent pas l'accès aux équipements électroniques montés dans lesdits boîtiers pour équipements.

2. Cadre de boîtier de base selon la revendication 1, caractérisé en outre par:
   une porte de sécurité articulée eu matière plastique transparente (46) sous ledit panneau supérieur articulé, ladite porte de sécurité permettant une observation visuelle des équipements électroniques montés à l'intérieur dudit boîtier, mais en restreignant l'accès.

3. Cadre de boîtier de base selon la revendication 1, caractérisé en outre par:
   des tiroirs verticaux pour cartes de circuits imprimés: (32) pour le montage de cartes de circuits imprimés à l'intérieur dudit boîtier pour équipement, lesdites cartes étant accessibles pour être insérées ou retirées dudit boîtier pour équipements par ouverture dudit panneau supérieur articulé, et une carte pouvant être insérée ou retirée après déconnexion des connecteurs de câbles de connexion de bords connectés à la carte sans gêne provoquée par des câbles qui sont connectés latéralement à d'autres cartes se trouvant dans le tiroir pour cartes et également sans gêne provoquée par ledit chemin de câbles.

4. Cadre de boîtier de base selon la revendication 1, caractérisé en outre par:
   un blindage conducteur monté derrière lesdites fentes (16) dans lesdits panneaux avant et arrière pour supprimer les interférences radioélectriques.

5. Cadre de boîtier de base selon la revendication 4, caractérisé en outre par:
   un moyen pour supprimer les émissions radioélectriques produites par les équipements électroniques à l'intérieur dudit boîtier pour équipements, ledit moyen de suppression étant monté pour fournir une étanchéité contre les interférences radioélectriques entre lesdits panneaux supérieur, avant latéral et arrière, lorsqu'ils sont fermés ou fixés sur ledit cadre de boîtier.

6. Cadre de boîtier de base selon la revendication 1, dans lequel ledit élément formant chemin de câbles comprend:
   un premier chen de câbles (17) monté de manière adjacente à l'avant dudit cadre et à son sommet,
   un second chemin de câbles (18) monté de manière adjacente à l'arrière dudit cadre et à son sommet, et
   un moyen de guidage de câble (35) dans ledit premier et ledit second chemins de câbles pour aider au positionnement des câbles sortant desdits deux chemins de câbles pour leur connexion à des cartes de circuits imprimes montées verticalement dans lesdits tiroirs pour cartes de circuits imprimés et à d'autres équipements électroniques de façon à ce que les cartes de circuits imprimés et les autres équipements électroniques puissent être insérés et retirés sans aucune gêne provoquée par des câbles connectés à d'autres cartes montées dans lesdits tiroirs pour cartes ou à d'autres équipements montés dans ledit boîtier pour équipements.

**Patentansprüche**

1. Gehäuse für ein elektronisches Gerät, das ein Grundgehäusegestell mit einer unteren pfannenartigen Vertiefung (62) aufweist, und das entfernbare Platten an der linken (12), an der rechten (13), an der vorderen (14) und an der hinteren (54) Seite aufweist, wobei die vordere und die hintere Platte Schlitze dadurch aufweisen für einen Durchfluß von Kühlluft, um über ein elektronisches Gerät (34) zu gehen, das innerhalb des Gehäuses montiert ist, dadurch gekennzeichnet, daß das Grundgehäusegestell aufweist:

eine schwenkbare obere Platte (19), die an der Spitze des Gehäusegestells montiert ist, wobei die obere Platte geöffnet werden kann, um einen Zugriff auf die elektronische Einrichtung innerhalb des Gerätegehäuses zu erlauben, und

ein kanalförmiges Kabelkanalelement (17), das innerhalb und benachbart zu der Spitze des Gerätegehäuses und parallel und benachbart zu jeder vorderen oder hinteren Platte montiert ist, wobei der Kabelkanal so positioniert ist, daß, wenn ein zweites ähnliches Gerätegehäuse benachbart zu dem Gerätegehäuse angeordnet ist, wobei die Seitenplatten zwischen den zwei Gehäusen entfernt sind, die Kabelkanäle in den benachbarten Gehäusen koaxial zueinander ausgerichtet sind und dadurch einen Pfad für Kabel schaffen, die zu und zwischen dem elektronischen Gerät verlaufen, das innerhalb der Gerätegehäuse montiert ist, und wobei der Kanal positioniert ist, um die Kabel so zu halten, daß sie einen Zugriff auf das elektronische Gerät nicht stören, das in den Gerätegehäusen montiert ist.

2. Grundgehäusegestell nach Anspruch 1, weiterhin gekennzeichnet durch:
eine schwenkbare durchsichtige Sicherheitstür aus Kunststoff (46) unterhalb der schwenkbaren oberen Platte, wobei die Sicherheitstür eine visuelle Beobachtung des elektronischen Gerätes zuläßt, das innerhalb des Gerätegehäuses montiert ist, aber einen Zugriff darauf beschränkt.

3. Grundgehäusegestell nach Anspruch 1, weiterhin gekennzeichnet durch:
vertikale Leiterplatten-Trogvorrichtungen (32) zum Montieren von Leiterplatten in dem Gerätegehäuse, wobei auf die Platten, um sie einzufügen oder von dem Gerätegehäuse zu entfernen, durch Öffnen der oberen Platte zugegriffen wird, und eine Platte kann eingefügt oder entfernt werden, nach einem Trennen von Kantenapschluß-Kabelverbindungsstücken, die mit der Platte verbunden sind, und zwar ohne eine Störung von Kabeln, die mit anderen Platten in der Platten-Trogvorrichtung kantenverbunden sind, und auch ohne Störung von dem Kabelkanal.

4. Grundgehäusegestell nach Anspruch 1, weiterhin gekennzeichnet durch:
eine leitfähige Abschirmung, die hinter den Schlitzen (16) in der vorderen und hinteren Platte montiert ist, um eine Radiofrequenz-Interferenzunterdrückung zu schaffen.

5. Grundgehäusegestell nach Anspruch 4, weiterhin gekennzeichnet durch:
eine Einrichtung zum Unterdrücken von Radiofrequenz-Emissionen, die durch das elektronische Gerät in dem Gerätegehäuse erzeugt werden, wobei die Unterdrückungseinrichtung montiert ist, um eine RFI-Dichtung zwischen der oberen und der seitlichen vorderen und der seitlichen hinteren Platte zu schaffen, wenn sie geschlossen sind oder an dem Gehäusegestell befestigt sind.

6. Grundgehäusegestell nach Anspruch 1, wobei das Kabelkanalelement aufweist:
einen ersten Kabelkanal (17), der benachbart zu der Front des Gestells an dessen Spitze montiert ist.
einen zweiten Kabelkanal (18) der benachbart zu der Rückwand des Gestells an dessen Spitze montiert ist, und
eine Kabelführungseinrichtung (35) in dem ersten und dem zweiten Kanal zum Helfen, Kabel zu positionieren, die beiden Kanäle zu verlassen, um Leiterplatten zu verbinden, die in den Leiterplatten-Trogvorrichtungen vertikal montiert sind, und mit einem anderen elektronischen Gerät, so daß die Leiterplatten und das andere elektronische Gerät ohne Störung von Kabeln eingefügt und entfernt werden können, die mit anderen Platten verbunden sind, die in den Platten-Trogvorrichtungen montiert sind, oder mit einem anderen Gerät, das in dem Gerätegehäuse montiert ist.

EP 0 247 522 B1

*Fig. 1.*

Fig. 2.

Fig. 3.

Fig. 4.